(19) Europäisches Patentamt
European Patent Office
Office européen des brevets

(11) **EP 3 510 373 B1**

(12) **EUROPÄISCHE PATENTSCHRIFT**

(45) Veröffentlichungstag und Bekanntmachung des Hinweises auf die Patenterteilung:
**06.01.2021   Patentblatt 2021/01**

(21) Anmeldenummer: **17803810.5**

(22) Anmeldetag: **02.11.2017**

(51) Int Cl.:
*G01M 15/14* *(2006.01)*      *G05B 19/048* *(2006.01)*
*G05B 23/02* *(2006.01)*      *G01B 21/04* *(2006.01)*
*G06F 30/23* *(2020.01)*

(86) Internationale Anmeldenummer:
**PCT/EP2017/078045**

(87) Internationale Veröffentlichungsnummer:
**WO 2018/086978 (17.05.2018 Gazette 2018/20)**

(54) **VERFAHREN ZUM BETREIBEN EINES IM BETRIEB ZYKLISCH BELASTETEN BAUTEILS**

METHOD FOR OPERATING A COMPONENT THAT IS CYCLICALLY LOADED DURING OPERATION

PROCÉDÉ DE FONCTIONNEMENT D'UN COMPOSANT SOLLICITÉ CYCLIQUEMENT EN FONCTIONNEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.11.2016   DE 102016221928**

(43) Veröffentlichungstag der Anmeldung:
**17.07.2019   Patentblatt 2019/29**

(73) Patentinhaber: **Siemens Aktiengesellschaft 80333 München (DE)**

(72) Erfinder:
• **GOTTSCHALK, Hanno**
  **44803 Bochum (DE)**
• **SAADI, Mohamed**
  **42103 Wuppertal (DE)**
• **SCHMITZ, Sebastian**
  **10437 Berlin (DE)**

(56) Entgegenhaltungen:
**EP-A1- 2 857 914     WO-A1-2015/071107**

• **Laura Bittner ET AL: "Optimal Reliability for Metal Components under Cyclic Loading", SIAM Journal on Control and Optimization Kallenberg. Random Measures. Akademie-Verlag, 1 January 1988 (1988-01-01), pages 2727-2752, XP055708659, Retrieved from the Internet: URL:http://www.mathematik.tu-dortmund.de/l six/events/UQ18/poster/poster_Bittner_UQ_2 018.pdf [retrieved on 2020-06-24]**

**Beschreibung**

Die Erfindung betrifft ein Verfahren zum Betreiben eines im Betrieb zyklisch belasteten Bauteils vorgegebener Geometrie Ω, bei dem

- eine Versagenswahrscheinlichkeit P für das Bauteil unter Berücksichtigung von Streuungen von Versagenszeiten, die durch Abweichungen von Materialeigenschaften bedingt werden, bestimmt wird,

- das Bauteil in Abhängigkeit von der bestimmten Versagenswahrscheinlichkeit P betrieben wird, wobei insbesondere in Abhängigkeit von der bestimmten Versagenswahrscheinlichkeit P wenigstens ein Wartungszeitpunkt für das Bauteil festgelegt wird.

Der sichere Betrieb mechanischer Komponenten, die im Betrieb zyklischen thermomechanischen Lasten ausgesetzt sind, ist in verschiedenen Bereichen von höchster Bedeutung. Als Beispiel solcher Komponenten seien Gasturbinen-Lauf- und Leitschaufeln, Rotorkomponenten und dergleichen genannt, die sowohl im Bereich des Flugbetriebes als auch des Betriebes gasbefeuerter Kraftwerke Verwendung finden. Dabei ist insbesondere von Interesse, über welchen Zeitraum ein Bauteil sicher betrieben werden kann bzw. zu welchem Zeitpunkt ein Versagen eines Bauteils voraussichtlich auftritt. Es hat sich jedoch herausgestellt, dass Versagenszeiten für mechanische Komponenten nur schwerlich vorhersagbar sind und einer beachtlichen Streuung hinsichtlich des Zeitpunktes des ersten Versagens unterliegen. Im Betrieb muss die Versagenswahrscheinlichkeit (engl.: probabiliy of failure, PoF) jedoch niedrig gehalten werden, um das ökonomische sowie funktionale Sicherheitsrisiko zu begrenzen, wie es beispielswiese durch Normen, wie etwa ISO 21789 für die Gasturbinensicherheit oder FAA (Federal Aviation Administration) Regularien für den Bereich des Flugbetriebes, beschrieben wird.

Unterliegen die Bauteile im Betrieb zyklischen thermischen sowie mechanischen Belastungen, führt dies zur Ermüdung der verwendeten Materialien und dadurch zur Bildung von Rissen, was in vielen Fällen die Bauteillebensdauer begrenzt. Von besonderer Bedeutung ist hier die sogenannte Kurzzeitschwingfestigkeit der Bauteile (engl.: low cycle fatigue, LCF).

Die Auslegung von Bauteilen erfolgt zumeist auf Basis von Materialkurven, wie sie beispielswiese über Materialtests an standardisierten Proben erhalten werden können. Dabei ist die deterministische Betrachtungsweise des Bauteilversagens vorherrschend. Eine Fehler-, insbesondere Anrisswahrscheinlichkeit wird bisher überwiegend nicht berechnet. Vielmehr werden pauschale Sicherheitsfaktoren lediglich über feste Abschläge in der zulässigen Bauteillebensdauer berücksichtigt, ohne dass quantitative Berechnungen stattfinden. Hiermit geht jedoch der Nachteil einher, dass Bauteile teilweise unnötig lange vor dem Erreichen Ihrer tatsächlichen Lebensdauer ausgetauscht bzw. gewartet werden, was die Wirtschaftlichkeit der die Bauteile umfassenden Maschinen bzw. Anlagen reduziert. Ein weiteres Problem dieser lediglich auf groben Schätzungen beruhenden Vorgehensweise besteht darin, dass ein Bauteil aufgrund spezifischer Eigenschaften bereits vor einem auf diese Weise prognostizierten Versagenszeitpunkt ausfallen kann, was dann mit Stillstandszeiten und den zugehörigen erheblichen wirtschaftlichen Nachteilen verbunden ist.

Die Bestrebungen im Stand der Technik sind daher dahin gegangen, Möglichkeiten zur genaueren Vorhersage von Bauteilversagen zu finden. Relevante Dokumente, die im Stand der Technik enthalten sind, sind z.B. EP2857914A1, WO2015071107A1 und die Publikation "Optimal Reliability for Metal Components under Cyclic Loading" von Laura Bittner und Hanno Gottschalk (SIAM Journal on Control and Optimization Kallenberg. Random Measures. Akademie-Verlag-North-Holland Springer).

In den Aufsätzen "Optimal reliability in design for fatigue life" von H. Gottschalk und S. Schmitz, preprint(2012), arXiv: 1210.4954 und "Risk estimation for LCF crack initiation" von S. Schmitz, G. Rollmann und H. Gottschalk, preprint (2012), arXiv: 1302.2902 sowie der EP 2 835 706 A1 ist eine Streuung der Versagenszeiten aufgrund der Materialeigenschaften der Bauteile beschrieben. Wichtige Materialeigenschaften sind hierbei z.B. der lokal vorliegende E Modul und Korngrößen, die u.a. vom individuellen Guss- und Fertigungsprozess abhängen.

Dabei wird die Versagenswahrscheinlichkeit in Bezug auf die Kurzzeitschwingfestigkeit (LCF) für eine gegebene Anzahl n von Lastzyklen durch die Formel

$$P(t|X) = 1 - e^{-t^m J(X)}$$

mit $J(X) = J(X, u(X)) = \int_{\partial\Omega} \left(\frac{1}{N_{det}(u)}\right)^m dA$ bestimmt.

Hierbei gibt Ω die mit Material gefüllte Region im dreidimensionalen Raum an, $\partial\Omega$ ist die Grenzfläche, dA ist das Oberflächenintegral und m ist ein Weibull-Formparameter. X ist ferner der Koordinatenvektor aller Knotenpunkte des Finiten Elemente Modells von Ω. $N_{det}(u)$ ist eine Skalierungsvariable, die von dem lokalen Spannungstensoren-Feld der finiten Elemente Lösung u des Verschiebungsfeldes abhängt. Der vorstehende Ausdruck kann, wie aus den beiden vorstehend zitierten Aufsätzen hervorgeht, unter Verwendung einer Finiten Elemente Analyse (FEA) Lösung des Spannungstensoren-Feldes und eines speziellen FEA Post-Prozessors numerisch berechnet werden.

Diese Vorgehensweise hat sich prinzipiell bewährt. Insbesondere kann, da nicht nur grobe Pauschalen angesetzt werden sondern eine Bestimmung einer Versagenswahrscheinlichkeit erfolgt, ein Betrieb mit gegenüber der vorbekannten Vorgehensweisen erhöhter Sicherheit und Wirtschaftlichkeit erzielt werden. Es besteht jedoch Bedarf an weiter verbesserten Verfahren.

Weiter ist aus dem Dokument EP 2 857 914 A1 ein Verfahren zur Qualitätskontrolle eines im Betrieb zyklisch belasteten Bauteils bekannt, bei dem eine Versagenswahrscheinlichkeit für das Bauteil bestimmt wird. Die Versagenswahrscheinlichkeit wird unter Berücksichtigung von Abweichungen der Bauteilform von einer Normgeometrie ermittelt, wobei zur Berücksichtigung der Formabweichung von der Normgeometrie insbesondere auf Daten zurückgegriffen wird, die durch messtechnische Bestimmung der Geometrie des Bauteils erhalten wurden.

Ausgehend von dem Stand der Technik ist es daher eine Aufgabe der vorliegenden Erfindung, ein Verfahren der eingangs genannten Art derart weiterzuentwickeln, dass es einen Betrieb eines Bauteils bzw. einer das Bauteil umfassenden Anlage oder Maschine mit gegenüber dem Stand der Technik erhöhter Sicherheit und erhöhter Wirtschaftlichkeit ermöglicht.

Diese Aufgabe wird bei einem Verfahren der eingangs genannten Art dadurch gelöst, dass

- die Versagenswahrscheinlichkeit P unter zusätzlicher Berücksichtigung von Streuungen von Versagenszeiten, die durch Abweichungen der Bauteilform von einer Normgeometrie bedingt werden, bestimmt wird,
  wobei zur Berücksichtigung der Formabweichung von der Normgeometrie insbesondere auf Daten zurückgegriffen wird, die durch messtechnische Bestimmung der Geometrie einer vorgegebenen Anzahl repräsentativer Bauteilen erhalten wurden,
  wobei die Versagenswahrscheinlichkeit P nach der Formel

$$P(t) \approx 1 - \frac{e^{-t^m[J+\Delta J]+\frac{1}{2}t^{2m}\sigma^2}\left(1 - \Phi\left(t^m\sigma - \frac{J+\Delta J}{\sigma}\right)\right)}{1 - \Phi\left(-\frac{J+\Delta J}{\sigma}\right)}$$

bestimmt wird, mit dem Koordinatenvektor X aller Knoten des finiten Elemente Models von der Geometrie Ω des Bauteils, dem diskretisierten objektiven Funktional $J(X) = J(X,U(X))$ für LCF (Low Cycle Fatigue) oder für einen anderen Fehlermechanismus, der Anzahl der Lastzyklen t, einem Formparameter der Weibullverteilung m, der Fehlerfunktion, das heißt der Distributionsfunktion der Standard-Normalverteilung $\Phi(t)$, sowie mit $J = J(X_d)$, wobei

$X_d$ die Normposition der Knoten bei der Normgeometrie ist, und mit $\Delta J = (dJ/dX)'\overline{\Delta X}$ mit der mittleren Prozessabweichung $\overline{\Delta X}$ und mit $\sigma^2 = (dJ/dX)'C(dJ/dX)$ mit der Prozessstreuung C.

Die vorliegende Erfindung basiert mit anderen Worten auf der Erkenntnis, dass neben einer Streuung in den Materialeigenschaften von unterschiedlichen Exemplaren eines gegebenen Bauteils auch Abweichungen der tatsächlichen Bauteilgeometrie von der vorgegebenen Soll- bzw. Normgeometrie einen erheblichen Einfluss auf die Streuung der Versagenszeitpunkte hat. Derartige Geometrieabweichungen liegen immer vor, da jedes Herstellungsverfahren gewissen Fertigungstoleranzen unterliegt. Bei der Herstellung von Bauteilen durch Gießen beispielsweise unterscheidet sich ein fertig hergestelltes Bauteil immer in einem gewissen Maße von der Soll- oder Normgeometrie, die beispielsweise in Form eines CAD-Datensatzes als Vorlage für den Fertigungsprozess dient. Wie stark die Abweichungen sind, kann von einer Vielzahl von Parametern abhängen und sich insbesondere von Hersteller zu Hersteller unterscheiden.

Erfindungsgemäß erfolgt eine integrierte Beurteilung der Versagenswahrscheinlichkeit, wobei Streuungen in den Versagenszeiten, die sowohl durch Materialeigenschaften als auch durch Herstellungstoleranzen bedingt sind, kombiniert berücksichtigt werden. In Folge dessen wird eine besonders genaue Bestimmung von Versagenswahrscheinlichkeiten möglich und es kann ein besonders sicherer und wirtschaftlicher Betrieb beispielswiese von einer ein betreffendes Bauteil umfassenden Maschine bzw. Anlage gewährleistet werden.

Unter der Versagenswahrscheinlichkeit P wird dabei die Wahrscheinlichkeit einer Rissbildung (engl. Crack Initiation Probability) verstanden.

Insbesondere kann ein sicherer Betrieb von Gasturbinen aber auch anderen mechanischen Komponenten, die im Betrieb zyklischen thermo-mechanischen Belastungen unterliegen, auf Basis kalkulierter Risikowerte erfolgen.

Es können ferner besonders zuverlässig Serviceintervalle für derartige Bauteile bzw. diese umfassende Anlagen oder Maschinen basierend auf akzeptierbaren Risikokriterien bestimmt werden. Fehleinschätzungen des Bauteilversagens werden zuverlässig vermieden.

Darüber hinaus wird es möglich, Hersteller bzw. Anbieter von Gasturbinen und anderen mechanischen Bauteilen auf Basis des Anwachsens der Versagenswahrscheinlichkeit, die durch die Herstellungstoleranzen der entsprechenden Anbieter verursacht werden, zu qualifizieren.

Dies war bisher nicht möglich, da Herstellungstoleranzen von Anbietern allein über die beispielsweise in ISO 2768-1 festgelegten Anforderungen bestimmt wurden, die jedoch nicht mit der Versagenswahrscheinlichkeit in Beziehung gesetzt wurden.

Erfindungsgemäß wird die aus dem Stand der Technik vorbekannte Prozedur, gemäß der die Versagenswahrscheinlichkeit allein unter Berücksichtigung der Streuung durch die Materialeigenschaften bestimmt wird, erweitert. Die Erweiterung ist derart, dass in der Formel für die Versagenswahrscheinlichkeit insbesondere zusätzlich durchschnittliche Geometrieabweichungen und die Streuung in den Geometrien berücksichtigt werden. Diese Größen werden bevorzugt während des oder nach dem des Herstellungsprozess für eine vorgegeben Anzahl repräsentativer Bauteile gemessen, wobei insbesondere eine Koordinatenmessmaschine, die ein Weißlichtinterferometer umfassen bzw. durch dieses gebildet sein kann, zum Einsatz kommt.

Die messtechnische Erfassung der tatsächlichen Bauteilgeometrie der repräsentativen Bauteile für die Berücksichtigung der Geometrie-Streuung kann insbesondere von dem Bauteil-Hersteller durchgeführt werden, der ohne Weiteres Zugriff auf eine Anzahl von baugleichen, unter gleichen Bedingungen gefertigten Bauteilen hat. Es können beispielswiese Geometriedaten Verwendung finden, die ohnehin von dem Hersteller im Rahmen der Qualitätskontrolle beispielswiese für Stichproben hergestellter Bauteile erfasst werden bzw. bereits wurden. Auch der Auftraggeber, also Abnehmer der Bauteile kann alternativ oder zusätzlich die Geometrie der gemessenen Bauteile erfassen. Die Geometrievermessung kann dann beispielsweise nach Wareneingang beim Auftraggeber durch diesen durchgeführt werden. Auch als vom Auftraggeber erfasste Daten können auch solche herangezogen werden, die dieser ohnehin im Rahmen seiner Wareneingangskontrolle erfasst.

Die zu vermessenden repräsentativen Bauteile müssen geeignet sein, repräsentative Werte für die Geometrieabweichung zu liefern, das heißt, sie sollten die gleiche Form aufweisen und vom gleichen Hersteller unter gleichen Herstellungsverfahren, wie z.B. gleicher Wärmebehandlung gefertigt worden sein.

Es versteht sich, dass es sowohl möglich ist, Geometriedaten nur von Stichproben, also nur von einem Teil aller von einem Hersteller gefertigter Bauteile einer Form heranzuziehen als auch Geometriedaten sämtlicher Bauteile, also eine Vollvermessung durchzuführen und die Ergebnisse dieser i die erfindungsgemäße Bestimmung der Versagenswahrscheinlichkeit einfließen zu lassen.

Eine Ausführungsform des erfindungsgemäßen Verfahrens zeichnet sich dadurch aus, dass zur messtechnischen Bestimmung der Geometrie der repräsentativen Bauteile jedes der repräsentativen Bauteile unter Verwendung einer koordinatenmessenden Maschine, die bevorzugt ein Weißlichtinterferometer umfasst oder durch dieses gebildet wird, vermessen wurde.

Über die messtechnische Bestimmung der Geometrie der repräsentativen Bauteile wird bzw. wurde insbesondere ein Satz von Koordinatenpunkten $x_{ij}$ erhalten, wobei i das jeweils vermessene Bauteil angibt und j einen jeweils gemessenen Norm-Punkt. Die Koordinaten $x_j$ wurden bzw. werden bevorzugt aus einem die Normgeometrie der Bauteile repräsentierenden CAD-Datensatz erhalten.

Die Koordinaten können ferner beispielsweise als Oberflächen-Gitterpunkte eines Finiten Elemente Analyse (FEA) Netzes gewählt werden.

Was die Herleitung der erfindungsgemäßen Gleichung für die Versagenswahrscheinlichkeit P angeht, gilt folgendes.

Ausgegangen wird von einer Versagenswahrscheinlichkeit über eine Anzahl von Lastzyklen t der Form

$$P(t|X) = 1 - e^{-t^{m}J(X)}.$$

Dabei ist X die geometrische Information (der Knotensatz) des Finite Element Modells einer mechanischen Komponente, $J(X) = J(X,U(X))$ das diskretisierte objektive Funktional für die Kurzzeitschwingfestigkeit (LCF) oder für einen anderen Fehlermechanismus und $X_d$ die Default-Position der Knoten, d.h. der Knotensatz, welcher von der Norm-Geometrie, die insbesondere als CAD-Geometrie vorliegen kann, erhalten wird.

In einem ersten Schritt wird die Formabweichung $\dfrac{dJ(X_d)}{dX}$ unter Verwendung der adjungierten Methode berechnet und zwar nach dem Verfahren, welches veröffentlicht wurde in dem Schlussbericht der AG Turbo 2020 mit dem Titel "Sensitivität der Ausfallwahrscheinlichkeit für thermisch und mechanisch belastete Gasturbinenkomponenten mittels adjungierter Verfahren" von Hanno Gottschalk, Stefan Kalisch, Mohamed Saadi, Teilverbundprojekt in Expansion, Vorhabensgruppe 4.1 - Gas und Dampfturbinenschaufeln, Vorhaben-Nr.: AG Turbo 20204.1.13. Dieser Abschlussbericht wurde bei der technischen Informationsbibliothek (TIP) Hannover unter der Signatur F16B381 akzessioniert.

Dann wird zur ersten Ordnung Taylor Expansion

$$J(X) \approx J(X_d) + \left(\frac{dJ(X_d)}{dX}\right)' (X - X_d).$$

Es wird davon ausgegangen, dass X eine Zufallsvariable ist. X wird bevorzugt unter Verwendung einer koordinatenmessenden Maschine, insbesondere unter Verwendung eines Weißlichtinterferometers gemessen, bevorzugt wird die Oberflächengeometrie repräsentativer Bauteile gescannt. Dies kann potentielles Netzmorphing zu den inneren Knoten einschließen kann. Bei einem Netzmorphing werden die inneren Knoten eines Finite Elemente Netzes in Abhängigkeit von der Verschiebung der Oberflächenknoten ebenfalls verschoben. Dies dient dazu, dass die Netzqualität der FEA durch die Deformation der Form nicht in Mitleidenschaft gezogen wird. Übliche Verfahren sind z.B. elliptische Netzglätter, die ihrerseits auf FEA-Methoden basieren.

Es sei weiterhin $X_0$ die mittlere Abweichung (d.h. die systematische Geometrieverschiebung in dem Herstellungsprozess der Bauteile) und C die Kovarianz von X (welche die Streuung in dem Herstellungsprozess repräsentiert).

Ausgehend von den für eine vorgegeben Anzahl repräsentativer Bauteile messtechnisch erfasster Koordinaten $x_{ij}$ wird bevorzugt die mittlere Herstellungsprozessabweichung am Punkt j bestimmt durch

$$\overline{\Delta x_j} = (1/n) \sum_i \left(x_{ij} - x_j\right) = (1/n) \sum_i \Delta x_{ij}$$

Insbesondere wird ferner bevorzugt die Kovarianzmatrix der Abweichungen durch

$$C_{jk} = \left(1/(n-1)\right) \sum_i \left(\Delta x_{ij} - \overline{\Delta x_j}\right)\left(\Delta x_{ik} - \overline{\Delta x_{ik}}\right)$$

bestimmt. Dabei stellt n die Anzahl der vermessenen Bauteile dar.

In einem nächsten Schritt kann dann ein einzelner Zufallsabweichungsvektor $\Delta X = (\Delta x_j)$ betrachtet werden. Für diese Abweichung kann eine Normalverteilung

$$\Delta X \sim N(\Delta x, C)$$

angenommen werden.

Man erhält

$$P(t) = \mathbb{E}_x[P(t,X)]$$

Es wurde versucht, diese Formel unter Anwendung der ersten Ordnung Taylor Expansion zu werten. Dabei hat sich jedoch gezeigt, dass der geradlinige Ansatz unter Verwendung der Kovarianztransformationsformel zusammen mit der bekannten Laplace Transformation für gauss'sche Zufallsvariablen

$$P(t) \approx 1 - \mathbb{E}_x \left[ e^{-t^m\left[J(X_d) + \left(\frac{dJ(X_d)}{dX}\right)'(X-X_d)\right]} \right] = e^{-t^m[J+\Delta J] + \frac{1}{2}t^{2m}\sigma^2}$$

mit

$$J = J(X_d), \qquad \Delta J = \left( \frac{dJ(X_d)}{dX} \right)' (X_0 - X_d)$$

und

$$\sigma^2 = \left( \frac{dJ(X_d)}{dX} \right)' C \frac{dJ(X_d)}{dX},$$

nicht zu einem zufriedenstellenden Ergebnis führt. Es hat sich gezeigt, dass die Überlebenswahrscheinlichkeit umso größer ausfällt, je größer der erste Ordnung Einfluss auf die Prozessstreuung für die Bauteilüberlebenswahrscheinlichkeit ist.

Darüber hinaus resultieren für große t negative Werte von P(t). In Folge dieser Defizite ist diese Gleichung für P(t) nicht für die industrielle Anwendung geeignet.

Eine nähere Analyse hat ergeben, dass das Problem in Verbindung mit den negativen Werten von

$$J(X) \approx \left[ J(X_d) + \left( \frac{dJ(X_d)}{dX} \right)' (X - X_d) \right]$$

steht, welche mit einiger (geringer) Wahrscheinlichkeit in Folge der ungebundenen gauss'schen Fluktuationen von X auftreten. Negative (näherungsweise) Werte von J(X) korrespondieren nicht mehr zu einer Weibull-Verteilung.

Dem wurde erfindungsgemäß damit begegnet, solche pathologischen Werte durch Konditionierung zu

$$\left[ J(X_d) + \left( \frac{dJ(X_d)}{dX} \right)' (X - X_d) \right]$$

auszuschließen. Der Fehler, welcher durch diese Konditionierung gemacht wird, ist konservativ, d.h. führt zur Vorhersage von zu hohen Versagenswahrscheinlichkeiten (vorausgesetzt das eine erste Ordnung Taylor Expansion gerechtfertigt ist). Dahinter steht, dass niedrige J(X) Werte zu niedrigeren Versagenswahrscheinlichkeiten führen. Somit stellen negative J(X) ein Leben "länger als unendlich dar", was durch die Konditionierung abgeschnitten wird. Es sei angemerkt, dass der Annäherungsfehler in Folge der ersten Ordnung Taylor Expansion mit verschiedenen Begründungen beurteilt werden sollte. Es ist zu beurteilen, ob die Prozessstreuung tatsächlich hinreichend klein ist, dass die Taylor-Entwicklung gerechtfertigt ist und der in der Veränderung der Ausfallwahrscheinlichkeit keine nichtlinearen Effekte in der Verformungsvariablen $(X - X_d)$ auftreten.

Somit wird eine neue approximierte Formel erhalten:

$$P(t) \approx 1 - \mathbb{E}_x \left[ e^{-t^m \left[ J(X_d) + \left( \frac{dJ(X_d)}{dX} \right)' (X - X_d) \right]} \middle| \left[ J(X_d) + \left( \frac{dJ(X_d)}{dX} \right)' (X - X_d) \right] > 0 \right]$$

In einem nächsten Schritt wird der Ausdruck auf der rechten Seite gewertet. Es wird begonnen mit

$$P \left( \left[ J(X_d) + \left( \frac{dJ(X_d)}{dX} \right)' (X - X_d) \right] > 0 \right) = 1 - \Phi \left( -\frac{J + \Delta J}{\sigma} \right),$$

was durch Standardisierung erhalten wird. Hier steht $\Phi(t)$ für die Fehlerfunktion, d.h. die Distributionsfunktion der standardnormalen Distribution.

Im nächsten Schritt wird durch unmittelbare Berechnung unter Verwendung der quadratischen Vervollständigung

$$(t^m \sigma)^2 + 2t^m y + (y/\sigma)^2 = \left(t^m \sigma + (y/\sigma)\right)^2 = \bar{y}^2$$

und einer Änderung der Variable $y \to \bar{y}$

$$\mathbb{E}_x \left[ e^{-t^m \left[ J(X_d) + \left( \frac{dJ(X_d)}{dX} \right)' (X - X_d) \right]} 1_{\left\{ J(X_d) + \left( \frac{dJ(X_d)}{dX} \right)' (X - X_d) > 0 \right\}} \right]$$

$$= e^{-t^m [J + \Delta J]} \frac{1}{\sqrt{2\pi}\sigma} \int_{-(J + \Delta J)}^{\infty} e^{-t^m y} e^{-\frac{1}{2} \left( \frac{y}{\sigma^2} \right)^2} dy$$

$$= e^{-t^m [J + \Delta J] + \frac{1}{2} t^{2m} \sigma^2} \left( 1 - \Phi \left( t^m \sigma - \frac{J + \Delta J}{\sigma} \right) \right).$$

Hier ist $1_A$ die Indikatorfunktion des Satzes A. Somit erhält man als Endergebnis für die angenäherte Formel

$$P(t) \approx 1 - \frac{e^{-t^m [J + \Delta J] + \frac{1}{2} t^{2m} \sigma^2} \left( 1 - \Phi \left( t^m \sigma - \frac{J + \Delta J}{\sigma} \right) \right)}{1 - \Phi \left( -\frac{J + \Delta J}{\sigma} \right)}$$

wobei

$$\Delta J = (dJ/dX)' \overline{\Delta X} \quad \text{und} \quad \sigma^2 = (dJ/dX)' C (dJ/dX).$$

Diese angepasste Formel wird erfindungsgemäß herangezogen, um die mittleren Prozessabweichungen $\overline{\Delta X}$ und die Prozessstreuung C für die Bestimmung Versagenswahrscheinlichkeit zu berücksichtigen.

Die Erfindung umfasst somit eine Kombination eines probabilistischen Versagenszeitmodells, eines adjungierten Verfahrens für die Berechnung von Formsensitivitäten, eine messtechnische Erfassung von Produktionsabweichungen, insbesondere unter Verwendung von Koordinaten-messenden Maschinen, die Interpolation der normalen Abweichungen eines Finite Elemente Netzes X, die statische Evaluation einer Mehrzahl solcher Messungen mit Mittel und Kovarianz, die zu einer systematischen Abweichung und einer Streuung des Herstellungsprozesses korrespondieren, und der Verwendung der erfindungsgemäßen Formel für die Versagenswahrscheinlichkeit zur Berechnung der Wahrscheinlichkeit der Rissbildung nach einer gegebenen Anzahl von Lastzyklen t, welche die Streuung der Materialeigenschaften, die Streuung des Herstellungsprozesses und die Prozessabweichungen, insbesondere des Turbinenschaufelgießens, berücksichtigt.

Die erfindungsgemäße Lösung für das vorgenannte Problem ist hoch effizient, da gegenüber dem Stand der Technik nur eine weitere Finite Elementen Lösung für den adjungierten Zustand erforderlich ist.

In Weiterbildung des erfindungsgemäßen Verfahrens ist vorgesehen, dass ein Grenzwert für die Versagenswahrscheinlichkeit P festgelegt, der Zeitpunkt bestimmt wird, an welchem die Versagenswahrscheinlichkeit den Grenzwert erreichen wird und dieser Zeitpunkt als Wartungszeitpunkt festgelegt wird. Beispielsweise kann eine maximal akzeptierbare Versagenswahrscheinlichkeit festgelegt werden, die zum Beispiel bei 10% liegen kann, und unter dieser Annahme kann die Anzahl von Zyklen bestimmt werden, nach welcher dieser Wert erreicht wird. Ein Wartungszeitpunkt wird dann bevorzugt auf einen Zeitpunkt unmittelbar nach dem Erreichen der Zyklenanzahl gelegt.

Alternativ oder zusätzlich kann auf Basis der bestimmten Versagenswahrscheinlichkeit P entschieden werden, ob der Herstellungsprozess des Bauteils für eine vorgegebene Anwendung des Bauteils ausreichende Qualitätsanforderungen erfüllt. Beispielsweise können Daten, insbesondere Koordinatensätze $x_{ij}$, für eine vorgegebene Anzahl repräsentativer Bauteile herangezogen werden, die von unterschiedlichen Herstellern produziert wurden und es kann für jeden Hersteller die Versagenswahrscheinlichkeit P in Abhängigkeit der Zyklenzahl unter Verwendung der erfindungsgemäße Formel bestimmt werden. Die erhaltenen Werte können untereinander und/oder mit vorgegebenen Grenzwerten verglichen werden und auf Basis des Vergleiches kann entschieden werden, ob die Hersteller gewünschte Qualitätsanforderungen erfüllen oder nicht.

Bei dem Bauteil, welches nach dem erfindungsgemäßen Verfahren betrieben wird, handelt es sich beispielsweise um ein Bauteil einer Gasturbine oder Dampfturbine oder eines Generators oder eines Strahltriebwerks oder einer Welle oder eines Flugzeugflügels.

Es versteht sich, dass nur eine einziges Bauteil, mehrere Bauteile oder auch alle Bauteile einer Maschine oder Anlage nach dem Verfahren gemäß der vorliegenden Erfindung betrieben werden können.

Weitere Merkmale und Vorteile der vorliegenden Erfindung werden anhand der nachfolgenden Beschreibung eines Verfahrens zum Betreiben eines Bauteils gemäß einer Ausführungsform der vorliegenden Erfindung unter Bezugnahme auf die beiliegende Zeichnung deutlich. Darin ist

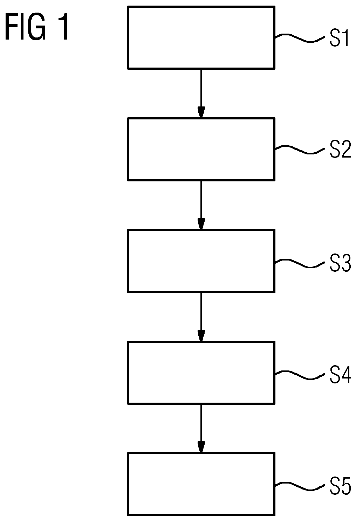

Figur 1 ein Ausführungsbeispiel des erfindungsgemäßen Verfahrens als Flussdiagramm,

Figur 2 ein Graph, in dem die Versagenswahrscheinlichkeit P über der Anzahl t von Lastzyklen für eine Normgeometrie und für eine gestreute Geometrie aufgetragen ist, und

Figur 3 ein Graph, in dem die Versagenswahrscheinlichkeit P über der Anzahl t von Lastzyklen für eine Normgeometrie und für eine gestreute Geometrie mit einer systematischen Verschiebung in J infolge von $\Delta J \neq 0$ aufgetragen ist.

Das erfindungsgemäße Verfahren zum Betreiben eines Bauteils gemäß dem dargestellten Ausführungsbeispiel beginnt in einem ersten Schritt S1 mit der Bereitstellung eines im Betrieb zyklisch belasteten Bauteils vorgegebener Geometrie $\Omega$, bei dem es sich vorliegend um eine in den Figuren nicht dargestellte Laufschaufel einer ebenfalls nicht dargestellten Gasturbine handelt.

In einem zweiten Schritt S2 werden Geometriedaten bereitgestellt, die durch messtechnische Bestimmung der Geometrie $\Omega$ einer vorgegebenen Anzahl von vorliegend 100 repräsentativen Bauteilen erhalten wurden. Die repräsentativen Bauteile, bei denen es sich ebenfalls um Laufschaufeln handelt, zeichnen sich - mit Ausnahme von Herstellungstoleranzen - durch die gleiche Geometrie aus wie das in Schritt S1 bereitgestellte Bauteil und wurden vom gleichen Hersteller und unter gleichem Herstellungsverfahren produziert.

Bei den für die repräsentativen Bauteile bereitgestellten Daten handelt es sich konkret um einen Satz von Koordinatenpunkten $x_{ij}$, der erstellt wurde, indem jedes der repräsentativen 100 Bauteile mittels einer Koordinatenmessmaschine, vorliegend einem Weißlichtinterferometer an einer vorgegebene Anzahl von Normpunkten vermessen wurde. Dabei gibt i das jeweils gemessene Bauteil an und j den jeweiligen Normpunkt. $x_{ij}$ stellt somit einen Vektor im dreidimensionalen Raum dar. Die korrespondierenden Koordinaten $x_j$ der Norm- oder Sollgeometrie der repräsentativen Bauteile wurden von einem CAD-Programm erhalten, konkret in Form eines für die Herstellung bereitgestellten CAD-Datensatzes der Bauteilgeometrie. Die Koordinaten wurden dabei als Oberflächen-Gitterpunkte eines Finiten Elemente Analyse (FEA) Netzes gewählt. Die messtechnisch erfassten Geometriedaten für die repräsentativen Bauteile wurden von dem Hersteller des bereitgestellten Bauteils unmittelbar nach der Herstellung der repräsentativen Bauteile unter Verwendung des Weißlichtinterferometers erfasst.

In einem nächsten Schritt S3 wird aus dem für die repräsentativen Bauteile bereitgestellten Satz von Koordinaten die mittlere Geometrieabweichung am Punkt j berechnet durch

$$\overline{\Delta x_j} = (1/n) \sum_i \left( x_{ij} - x_j \right) = (1/n) \sum_i \Delta x_{ij}$$

und die Kovarianzmatrix der Abweichungen durch

$$C_{jk} = \left( 1/(n-1) \right) \sum_i \left( \Delta x_{ij} - \overline{\Delta x_j} \right) \left( \Delta x_{ik} - \overline{\Delta x_{ik}} \right).$$

Es wird ein einzelner Zufallsabweichungsvektor $\Delta X = (\Delta x_j)$ betrachtet. Für diese Abweichung kann eine Normalverteilung

$$\Delta X \sim N(\Delta x, C)$$

angenommen werden.

Anschließend wird in Schritt S4 unter Verwendung der erfindungsgemäßen Formel

$$P(t) \approx 1 - \frac{e^{-t^m[J+\Delta J]]+\frac{1}{2}t^{2m}\sigma^2}\left(1 - \Phi\left(t^m\sigma - \frac{J+\Delta J}{\sigma}\right)\right)}{1 - \Phi\left(-\frac{J+\Delta J}{\sigma}\right)}$$

mit $\Delta J = (dJ/dX)'\overline{\Delta X}$ und $\sigma^2 = (dJ/dX)'C(dJ/dX)$ eine Versagenswahrscheinlichkeit P für das bereitgestellte Bauteil bestimmt.

Dabei wird im Rahmen des vorliegenden Ausführungsbeispiels m = 1.5 gewählt, was im Bereich der Weibull-Formparameter der probabilistischen Kurzzeitschwingfestigkeit (LCF) liegt. Es wird weiterhin für das vorliegende Beispiel $J = \left(\frac{1}{3000}\right)^m$ angesetzt, was zu 3000 Zyklen als das $1 - \frac{1}{e} \approx 0{,}63$ Quantil der Weibull-Distribution der Versagenswahrscheinlichkeit der Normgeometrie korrespondiert Es wird ferner zunächst davon ausgegangen, dass $\Delta J = 0$ ist, was bedeutet, dass der Herstellungsprozess um die Normalgeometrie zentriert ist, also $X_d = X_0$, d.h. die Geometrieabweichungen der 100 repräsentativen Bauteile von der CAD-Normgeometrie ist im Mittel null.

Schließlich wird $\sigma = 0{,}6 * J$ angenommen, was bedeutet, die 1$\sigma$-Streuung in $J(X)$ ist 60% des Asboluten $J = J(X_d)$ Wertes, was etwa 5% der Fälle mit negativer Approximation für $J(X)$ einkalkuliert.

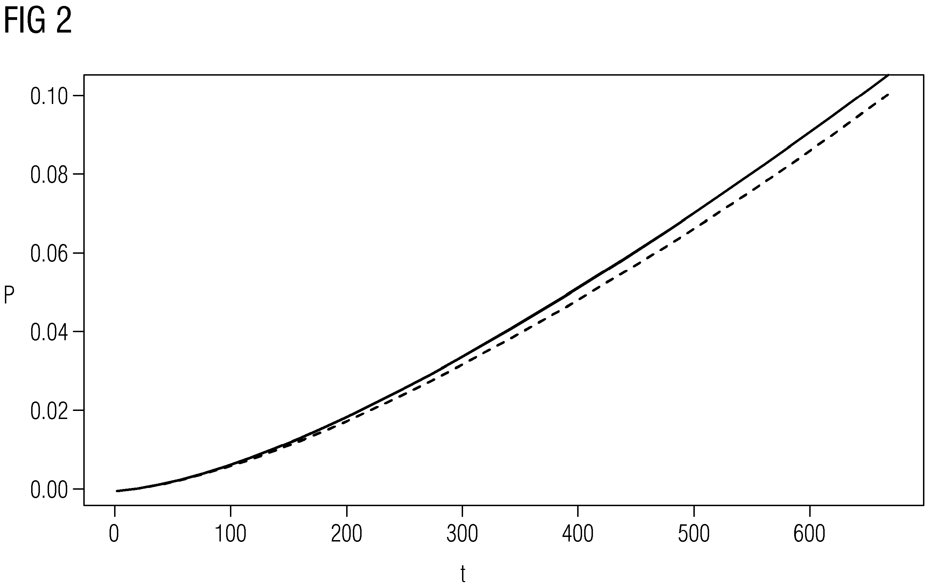

In der Figur 2 ist mit durchgezogener Linie die resultierende Versagenswahrscheinlichkeit P(t) über der Zyklenanzahl t dargestellt. Ebenfalls eingezeichnet ist die Versagenswahrscheinlichkeit P(t), welche sich ohne die erfindungsgemäße Berücksichtigung der Geometriestreuung ergibt und zwar in gestrichelter Linie. Diese Versagenswahrscheinlichkeit P ist nach der aus dem Stand der Technik vorbekannten Formel, welche allein die Streuung infolge von Materialeigenschaften nicht jedoch die infolge von Geometrieabweichungen berücksichtigt, berechnet worden (vgl. die EP 2 835 706 A1).

Die erfindungsgemäße Berücksichtigung der Geometriestreuung scheint auf den ersten Blick zu moderaten Abweichungen zu führen. Geht man jedoch davon aus, dass das maximal akzeptierbare Risiko für die LCF Rissbildung bei einer Versagenswahrscheinlichkeit von 10% liegt, erhält man unter Berücksichtigung allein der Streuung infolge von Materialeigenschaften eine Zyklenanzahl von $t = 670$. Unter erfindungsgemäßer zusätzlicher Berücksichtigung der geometrischen Streuung ergibt sich hingegen eine Zyklenanzahl von $t = 648$. Die gemäß dem Ausführungsbeispiel maximal akzeptierbare Versagenswahrscheinlichkeit wird also bereits 22 Zyklen vorher erreicht. Die Tatsache, dass 22 Zyklen einen erheblichen ökonomischen Wert darstellen unterstreicht die Bedeutung der scheinbar moderaten Änderung infolge der erfindungsgemäßen Vorgehensweise.

In einem letzten Schritt S5 wird das bereitgestellte Bauteil in Abhängigkeit der bestimmten Versagenswahrscheinlichkeit betrieben. Konkret wird festgelegt, dass bei Erreichen der maximal tolerierbaren Versagenswahrscheinlichkeit von 10% also nach 648 Zyklen, eine Wartung des Bauteils durchgeführt wird.

Da erfindungsgemäß zusätzlich die Geometriestreuung bei der Bestimmung der Versagenswahrscheinlichkeit P berücksichtigt wird, die zu einem früheren Erreichen der maximal tolerierbaren Versagenswahrscheinlichkeit führt, kann ein besonders sicherer und besonders wirtschaftlicher Betrieb der die betrachtete Laufschaufel umfassenden Gasturbine gewährleistet werden. Denn die Wartung(splanung) erfolgt auf Basis berechneter Risikowerte, in denen auch die Streuung der Versagenszeitpunkte infolge der Geometriestreuung berücksichtigt wurde. Fehleinschätzungen des Bauteilversagens werden zuverlässig vermieden.

Es sei angemerkt, dass sich gezeigt hat, dass der Einfluss des Vorhandenseins einer systematischen Abweichung des Herstellungsprozesses, die in eine systematische Geometrieabweichung resultiert, auf die Versagenswahrscheinlichkeit deutlich signifikanter ist.

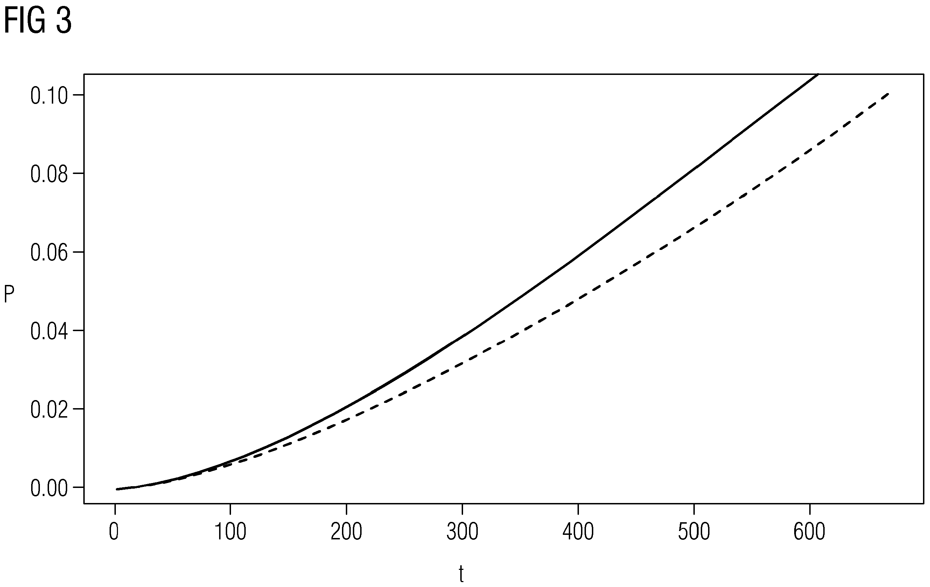

Zur Verdeutlichung dieses Effektes wird das vorstehend beschriebene Ausführungsbeispiel derart abgeändert, dass $\Delta J = 0{,}2 * J$ anstelle von $\Delta J = 0$ angenommen wird. Dies entspricht einer Änderung von 10% des J-Wertes infolge einer Differenz von $X_0 - X_d$. Das Ergebnis kann der Figur 3 entnommen werden, in welcher erneut die Versagenswahrscheinlichkeit P einmal unter erfindungsgemäßer zusätzlicher Berücksichtigung der Geometriestreuung in durchgezogener Linie und einmal gemäß dem Stand der Technik in gestrichelter Linie dargestellt ist. Man erkennt, dass die maximal akzeptierbare Versagenswahrscheinlichkeit von 10% nunmehr unter erfindungsgemäßen zusätzlicher Berücksichtigung der Geometriestreuung und mit systemtaischer Abweichung, also für $\Delta J = 0{,}2 * J$, bereits bei 568 Zyklen erreicht wird. Gegenüber der Zyklenzahl von 670 ohne erfindungsgemäße Berücksichtigung der Geometriestreuung wird die maximal akzeptable Versagenswahrscheinlichkeit also bereist 102 Zyklen früher erreicht. Dies verdeutlicht, dass bei Vorhandensein einer systematischen Abweichung in dem Bauteil-Herstellungsprozess die erfindungsgemäße Vorgehensweise von besonderer Bedeutung ist, da nur so erhebliche Fehleinschätzungen des Bauteilversagens vermieden werden können.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang, definiert durch die Ansprüche 1-8, der Erfindung zu verlassen.

**Patentansprüche**

1.  Verfahren zum Betreiben eines im Betrieb zyklisch belasteten Bauteils vorgegebener Geometrie $\Omega$, bei dem

    - eine Versagenswahrscheinlichkeit P für das Bauteil unter Berücksichtigung von Streuungen von Versagenszeiten, die durch Abweichungen von Materialeigenschaften bedingt werden, bestimmt wird,
    - das Bauteil in Abhängigkeit von der bestimmten Versagenswahrscheinlichkeit P betrieben wird (S5), wobei insbesondere in Abhängigkeit von der bestimmten Versagenswahrscheinlichkeit P wenigstens ein Wartungszeitpunkt für das Bauteil festgelegt wird,

    **dadurch gekennzeichnet, dass**

    - die Versagenswahrscheinlichkeit P unter zusätzlicher Berücksichtigung von Streuungen von Versagenszeiten, die durch Abweichungen der Bauteilform von einer Normgeometrie bedingt werden (S3), bestimmt wird, wobei zur Berücksichtigung der Formabweichung von der Normgeometrie insbesondere auf Daten zurückgegriffen wird, die durch messtechnische Bestimmung der Geometrie einer vorgegebenen Anzahl repräsentativer Bauteilen erhalten wurden,
    wobei die Versagenswahrscheinlichkeit P nach der Formel

    $$P(t) \approx 1 - \frac{e^{-t^m [J + \Delta J] + \frac{1}{2} t^{2m} \sigma^2} \left( 1 - \Phi \left( t^m \sigma - \frac{J + \Delta J}{\sigma} \right) \right)}{1 - \Phi \left( -\frac{J + \Delta J}{\sigma} \right)}$$

    (S4) bestimmt wird, mit dem Koordinatenvektor X aller Knoten des finiten Elemente Models von der Geometrie $\Omega$ des Bauteils, dem diskretisierten objektiven Funktional $J(X) = J(X, U(X))$ für LCF (Low Cycle Fatigue) oder für einen anderen Fehlermechanismus, der Anzahl der Lastzyklen t, einem Formparameter der Weibullverteilung m, der Fehlerfunktion, das heißt der Distributionsfunktion der Standard-Normalverteilung $\Phi(t)$, sowie mit $J = J(X_d)$, wobei $X_d$ die Normposition der Knoten bei der Normgeometrie ist, und mit $\Delta J = (dJ/dX)' \overline{\Delta X}$ mit der mittleren Prozessabweichung $\overline{\Delta X}$ und mit $\sigma^2 = (dJ/dX)' C(dJ/dX)$ mit der Prozessstreuung C.

2.  Verfahren nach Anspruch 1,
    **dadurch gekennzeichnet, dass**
    zur messtechnischen Bestimmung der Geometrie der repräsentativen Bauteile jedes der repräsentativen Bauteile unter Verwendung einer koordinatenmessenden Maschine, die bevorzugt ein Weißlichtinterferometer umfasst oder durch dieses gebildet wird, vermessen wurde.

3.  Verfahren nach Anspruch 2,
    **dadurch gekennzeichnet, dass**
    über die messtechnische Bestimmung der Geometrie der repräsentativen Bauteile ein Satz von Koordinatenpunkten $x_{ij}$ erhalten wurde, wobei i das jeweils vermessene Bauteil angibt und j einen jeweils gemessenen Norm-Punkt, wobei die Koordinaten $x_j$ insbesondere aus einem die Normgeometrie der Bauteile repräsentierenden CAD-Datensatz erhalten wurden.

4.  Verfahren nach Anspruch 3,
    **dadurch gekennzeichnet, dass**
    die Koordinaten als Oberflächen-Netz-Punkte eines finite Elemente Analyse Netzes gewählt werden.

5.  Verfahren nach Anspruch 3 oder 4,

**dadurch gekennzeichnet, dass**
die mittlere Herstellungsprozessabweichung am Punkt j durch

$$\overline{\Delta x_j} = (1/n) \sum_i \left(x_{ij} - x_j\right) = (1/n) \sum_i \Delta x_{ij}$$

und die Kovarianzmatrix der Abweichungen durch

$$C_{jk} = \left(1/(n-1)\right) \sum_i \left(\Delta x_{ij} - \overline{\Delta x_j}\right)\left(\Delta x_{ik} - \overline{\Delta x_{ik}}\right)$$

bestimmt wird, wobei i das jeweils gemessene Bauteil angibt.

6. Verfahren nach einem der vorhergehenden Ansprüche,
   **dadurch gekennzeichnet, dass**
   ein Grenzwert für die Versagenswahrscheinlichkeit P festgelegt, der Zeitpunkt bestimmt wird, an welchem die Versagenswahrscheinlichkeit den Grenzwert erreichen wird und dieser Zeitpunkt als Wartungszeitpunkt festgelegt wird.

7. Verfahren nach einem der vorhergehenden Ansprüche,
   **dadurch gekennzeichnet, dass**
   auf Basis der bestimmten Versagenswahrscheinlichkeit P entschieden wird, ob der Herstellungsprozess des Bauteils für eine vorgegebene Anwendung des Bauteils ausreichende Qualitätsanforderungen erfüllt.

8. Verfahren nach einem der vorhergehenden Ansprüche,
   **dadurch gekennzeichnet, dass**
   das Bauteil ein Bauteil einer Gasturbine oder Dampfturbine oder eines Generators oder eines Strahltriebwerks oder einer Welle oder eines Flugzeugflügels ist.

**Claims**

1. Method for operating a component of predetermined geometry $\Omega$ that is cyclically loaded during operation, wherein

   - a probability of failure P is determined for the component taking account of distributions of failure times, which are caused by deviations in material properties,
   - the component is operated (S5) depending on the determined probability of failure P, wherein at least one maintenance time is set for the component, in particular depending on the determined probability of failure P,
   **characterized in that**
   - the probability of failure P is determined taking additional account of distributions of failure times, which are caused (S3) by deviations of the component form from a standard geometry,

   wherein, in particular, data that were obtained by determining the geometry of a predetermined number of representative components by metrology are resorted to for the purposes of taking account of the form deviation from the standard geometry,
   wherein the probability of failure P is determined according to the formula (S4)

$$P(t) \approx 1 - \frac{e^{-t^m[J+\Delta J] + \frac{1}{2}t^{2m}\sigma^2} \left(1 - \Phi\left(t^m\sigma - \frac{J+\Delta J}{\sigma}\right)\right)}{1 - \Phi\left(-\frac{J+\Delta J}{\sigma}\right)},$$

   with the coordinate vector X of all nodes of the finite element model of the geometry $\Omega$ of the component, the discretized objective functional $J(X) = J(X, U(X))$ for LCF (low cycle fatigue) or for another fault mechanism, the number of load cycles t, a form parameter of the Weibull distribution m, the error function, i.e., the distribution function of the standard normal distribution $\Phi(t)$, and with $J = J(X_d)$, where $X_d$ is the standard position of the nodes in the standard geometry, and with $\Delta J = (dJ/dX)'\overline{\Delta X}$ with the mean process deviation $\overline{\Delta X}$ and with $\sigma^2 = (dJ/dX)'C(dJ/dX)$ with the process distribution C.

2. Method according to Claim 1,
**characterized in that**
each of the representative components was measured using a coordinate measuring machine, which preferably comprises a white light interferometer or is formed by the latter, for the purposes of determining the geometry of the representative components by metrology.

3. Method according to Claim 2,
**characterized in that**
a set of coordinate points $x_{ij}$ was obtained by determining the geometry of the representative components by metrology, where i specifies the respectively measured component and j specifies a respectively measured standard point, wherein the coordinates $x_j$ were obtained, in particular, from a CAD data record that represents the standard geometry of the components.

4. Method according to Claim 3,
**characterized in that**
the coordinates are chosen as surface mesh points of a finite element analysis mesh.

5. Method according to Claim 3 or 4,
**characterized in that**
the mean production process deviation at the point j is determined by

$$\overline{\Delta x_j} = (1/n) \sum_i \left( x_{ij} - x_j \right) = (1/n) \sum_i \Delta x_{ij}$$

and the covariance matrix of the deviations is determined by

$$c_{jk} = (1/(n-1))(1/n) \sum_i \left( \Delta x_{ij} - \overline{\Delta x_j} \right)(\Delta x_{ik} - \overline{\Delta x_{ik}}),$$

where i specifies the respectively measured component.

6. Method according to any one of the preceding claims,
**characterized in that**
a limit is set for the probability of failure P, said limit determining the time at which the probability of failure will reach the limit and this time is set as maintenance time.

7. Method according to any one of the preceding claims,
**characterized in that**
a decision as to whether the production process of the component satisfies sufficiently stringent quality requirements for a specified application of the component is made on the basis of the determined probability of failure P.

8. Method according to any one of the preceding claims,
**characterized in that**
the component is a component of a gas turbine or a steam turbine or of a generator or of a jet engine or of a shaft or of an aircraft wing.

**Revendications**

1. Procédé pour faire fonctionner un composant, de géométrie $\Omega$ donnée à l'avance, sollicité cycliquement en fonctionnement, dans lequel

- on détermine une probabilité P de défaillance du composant en tenant compte de dispersions de temps de défaillance, qui sont provoquées par des écarts dans les propriétés du matériau,
- on fait fonctionner (S5) le composant en fonction de la probabilité P de défaillance, qui a été déterminée, dans lequel, en particulier, on fixe au moins un point dans le temps pour l'entretien du composant en fonction de la probabilité P de défaillance, qui a été déterminée,

**caractérisé en ce que**

- on détermine la probabilité P de défaillance en tenant compte, en outre, de dispersions de temps de défaillance, qui sont provoquées (S3) par des écarts de la forme du composant à une géométrie de norme, dans lequel, pour tenir compte de l'écart de forme à la géométrie de norme, on s'en remet notamment à des données, qui ont été obtenues par une détermination en technique de mesure de la géométrie d'un nombre donné à l'avance de composants représentatifs, dans lequel on détermine (S4) la probabilité P de défaillance par la formule

$$P(t) \approx 1 - \frac{e^{-t^{m[j+\Delta]+\frac{1}{2}}\, t^{2m\sigma 2}}\left(1 - \Phi\left(tm\sigma - \dfrac{J+\Delta J}{\sigma}\right)\right)}{1 - \Phi\left(-\dfrac{J+\Delta J}{\sigma}\right)}$$

avec le vecteur X de coordonnées de tous les nœuds du modèle en éléments finis de la géométrie $\Omega$ de la pièce, la fonction objective discrétisée $J(X) = J(X,U(X))$ pour LCF (Low Cycle Fatigue) ou pour un autre mécanisme de défaut, le nombre de cycles t de sollicitation, un paramètre de forme de la répartition m de Weibull, la fonction de défaut, c'est-à-dire la fonction de distribution de la répartition $\Phi(t)$ normale standard, ainsi que $J = (JX_d)$, $X_d$ étant la position de norme des nœuds à la géométrie de norme, et $\Delta J = (dJ/dX)'\overline{\Delta X}$ avec $\overline{\Delta X}$ étant l'écart moyen de processus et $\sigma^2 = (dJ/dX)'C(dJ/dX)$, C étant la dispersion de processus.

**2.** Procédé suivant la revendication 1,
**caractérisé en ce que**
pour la détermination en technique de mesure de la géométrie des composants représentatifs, on a mesuré chacun des composants représentatifs en utilisant une machine de mesure de coordonnées, qui comprend, de préférence, un interféromètre en lumière blanche ou qui en est formée.

**3.** Procédé suivant la revendication 2,
**caractérisé en ce que**,
par la détermination en technique de mesure de la géométrie des composants représentatifs, on a obtenu un ensemble de points $x_{ij}$ de coordonnées, i indiquant, respectivement, le composant mesuré et j un point norme mesuré, respectivement, les coordonnées $x_j$ ayant été obtenues notamment à partir d'un ensemble de données CAD représentant la géométrie de norme des composants.

**4.** Procédé suivant la revendication 3,
**caractérisé en ce que**
l'on choisit les coordonnées sous la forme de points de réseau de surface d'un réseau d'analyse en éléments finis.

**5.** Procédé suivant la revendication 3 ou 4,
**caractérisé en ce que**
l'on détermine l'écart de processus de fabrication moyen au point j par

$$\overline{\Delta x_j} = (1/n)\sum_i (x_{ij} - x_j) = (1/n)\sum_i \Delta x_{ij}$$

et la matrice de covariance des écarts par

$$C_{jk} = (1/(n-1)) \sum_i (\Delta x_{ij} - \overline{\Delta x_j})(\Delta x_{ik} - \overline{\Delta x_{ik}})$$

i indiquant le composant mesuré, respectivement.

6. Procédé suivant l'une des revendications précédentes,
**caractérisé en ce que**
l'on fixe une valeur limite de la probabilité P de défaillance, on détermine l'instant où la probabilité de défaillance atteint la valeur limite et on fixe cet instant comme point dans le temps de l'entretien.

7. Procédé suivant l'une des revendications précédentes,
**caractérisé en ce que**,
sur la base de de la probabilité P de défaillance, qui a été déterminée, on décide si le processus de fabrication du composant satisfait des exigences de qualité suffisantes pour une utilisation donnée à l'avance du composant.

8. Procédé suivant l'une des revendications précédentes,
**caractérisé en ce que**
le composant est un composant d'une turbine à gaz ou d'une turbine à vapeur ou d'un générateur ou d'un moteur à réaction ou d'un arbre ou d'une aile d'aéronef.

FIG 1

FIG 2

EP 3 510 373 B1

FIG 3

EP 3 510 373 B1

**IN DER BESCHREIBUNG AUFGEFÜHRTE DOKUMENTE**

**In der Beschreibung aufgeführte Patentdokumente**

- EP 2857914 A1
- WO 2015071107 A1

- EP 2835706 A1


**In der Beschreibung aufgeführte Nicht-Patentliteratur**

- Optimal Reliability for Metal Components under Cyclic Loading. **LAURA BITTNER ; HANNO GOTTSCHALK.** SIAM Journal on Control and Optimization Kallenberg. Random Measures. Akademie-Verlag-North-Holland Springer

- **H. GOTTSCHALK ; S. SCHMITZ.** Optimal reliability in design for fatigue life. *preprint(2012), arXiv: 1210.4954,* 2012
- **S. SCHMITZ ; G. ROLLMANN ; H. GOTTSCHALK.** Risk estimation for LCF crack initiation. *preprint (2012), arXiv: 1302.2902,* 2012